# EUROPEAN PATENT SPECIFICATION

(11) **EP 0 468 805 B1**
(45) Date of publication and mention of the grant of the patent: **13.09.1995**
(21) Application number: 91306832.6
(22) Date of filing: 26.07.1991
(51) Int. Cl.: B66F 17/00, B60L 3/00, G01R 31/00

(54) **A diagnostic system for a material handling vehicle**
Eine Diagnoseeinrichtung für ein Materialhandhabungsfahrzeug
Un système de diagnostic pour un véhicule de manutention de matériaux

(30) Priority: 27.07.1990 US 559236
(43) Date of publication of application: 29.01.1992
(73) Proprietor: RAYMOND CORPORATION, Greene, New York 13778 (US)
(72) Inventor: Simmons, James Miles, Jr., Newark Valley, NY 13811 (US); Bachman, Michael Scott, Port Crane, NY 13833 (US); Kellogg, David Lawrence, Greene, NY 13778 (US); Avitan, Isaac, Vestal, NY 13850 (US)
(74) Representative: Vetter, Ewald Otto, Dipl.-Ing.

(56) References cited:
- EP-A- 0 277 782
- EP-A- 0 343 839
- EP-A- 0 376 206
- EP-A- 0 416 171
- WO-A-84/02787
- DE-A- 3 309 867
- US-A- 4 126 237

## Description

The present invention relates to battery powered industrial material handling vehicles, such as fork lift trucks. More particularly, the invention relates to a diagnostic system and method for automatically performing startup diagnostic testing of such vehicles to ensure subsequent normal operation. Such prior diagnostic tests can detect any abnormal conditions that would interfere with operation, before the equipment is put into service.

It will be readily appreciated by those skilled in the art, that various kinds of unsafe, unwanted, unexpected and abnormal conditions may occur during the operation of material handling equipment. These conditions usually result from defective components and/or improper or untimely interruption or connection of various current paths and subsystems of the power circuitry.

A diagnostic system of this type is known from the WO-A-84/02787, wherein an apparatus for diagnosing and displaying the condition of various components in an electromechanical vehicle or other system is presented. The apparatus includes command signal producing devices, control signal receiving devices, and means for delivering control signals to the receiving devices in response to receiving the produced command signals. The means includes means for receiving diagnostic command signals and displaying a predetermined diagnostic code in response to receiving a predetermined command signal. Both in-service and out-of-service diagnostics are provided for.

This invention has as one of its objectives to provide an automatic monitoring or diagnostic system for testing the key components and subsystems of a material handling vehicle. Such automated testing will significantly improve the safe operation of the vehicle. Such pre-operational inspections will decrease the mean time to repair (MTTR) intervals for the truck.

It would be advantageous to provide a diagnostic procedure for performing an automatic, sequential check of the various critical electric power paths at startup in a fork lift truck power system.

It would also be advantageous to detect and signal the presence of any abnormalities prior to a planned maintenance or service schedule.

It would also be advantageous to provide a safety system for such a fork lift truck in order to monitor circuit conditions automatically at startup and initiate a preemptive service operation when a critical abnormality is detected.

It would also be advantageous to check the proper operational capabilities of critical motive mechanisms and components of a material handling vehicle prior to its use, rather than merely determining whether power is properly applied to such mechanisms, as is the current state of the art.

It would also be advantageous to provide a diagnostic check of components and circuitry before, during and after activation thereof.

These and other objects of this invention will become more apparent, and will be better understood with reference to the subsequent detailed description considered in conjunction with the accompanying drawings.

### SUMMARY OF THE INVENTION

In accordance with the present invention, there is provided a diagnostic system according to claim 10 and a fail safe method according to claims 1 and 15 for performing diagnostics tests on a plurality of components and subsystems of a material handling vehicle. The diagnostics are executed upon the vehicle in a quiescent, or non-operative state. The operational capacity of the critical components is tested prior to the vehicle going on line.

Each particular subsystem of the vehicle is selected and tested in an ordered, diagnostic sequence. Each subsystem has a mechanism for activating it. The operational state of a particular subsystem is determined by sensing that subsystem in a predetermined sequence of testing events. A predetermined voltage is applied to the mechanism for activating the subsystem once it has been determined that the subsystem is inactive. After a predetermined activation time, a measurement is performed to determine whether the subsystem has been activated and is responding properly to the activating procedures.

Various subsystems depend upon other components or subsystems for their proper operation. By providing an ordered diagnostic sequence, a potential trouble area is easily diagnosed.

Different sequences and measurements are possible within the scope of the invention as defined in the claims, and provide the diagnostic flexibility required with complex and interdependent subsystems.

The inventive diagnostic system does not merely prescribe a particular operating voltage or current to a component or subsystem, but rather measures and compares the response of the particular component or subsystem with respect to a prior conditional response.

A comprehensive understanding of the present invention may be obtained by reference to the accompanying drawings, in which:
FIGURE 1 is a schematic representation of a fork lift vehicle having a plurality of operating components and subsystems;
FIGURE 2 is an electrical schematic diagram of a set of sub-systems and components of the fork lift vehicle shown in FIGURE 1, and mechanisms for activating these subsystems and components in accordance with the sequential diagnostic program of this invention; and
FIGURES 3a through 3g depict a series of flow charts representing a diagnostic sequence of steps for testing the plurality of subsystems and components, previously illustrated in FIGURES 1 and 2.

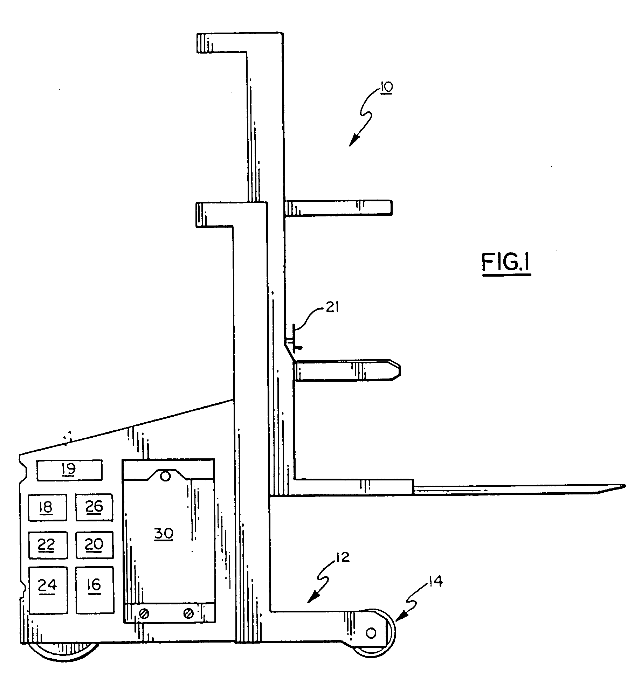

Referring now to FIGURE 1, there is shown schematically an exemplary form of industrial material handling vehicle to which the present invention may be applied, such as a fork lift truck, referred to generally as reference numeral 10. Truck 10 has a mobile chassis 12 supported by conventionally mounted wheels 14. Truck 10 includes a traction motor 16 supported upon the chassis 12 for propulsion of the truck 10. A traction motor control system 18 is provided for speed and direction control of the vehicle. A system controller 19, having an internal power supply, a steering mechanism 20, a braking system 22, a lift motor 24, a lift motor control system 26, and a battery pack 30, are also carried by the chassis 12.

A steering wheel 21 is connected to steering mechanism 20 by means well known in the art. Battery pack 30 powers the system controller 19, which in turn controls traction motor control system 18 and lift motor control system 26.

Normal operation of the lift truck may be performed through a remote radio control system or other signal carrying linkage, not shown, or in the usual manner by a riding operator exercising manual control of the vehicle from a control cab. In either case, diagnostic interrogation and monitoring of key components and subsystems of the several on-board motive systems, according to the present invention, provides assurance of reliable, predictable and safe operation.

According to the invention, the various subsystems and key components of the operating circuitry for the truck are diagnosed or interrogated in sequence. The specific sequence is logically selected to ensure that each component in the system is operative and that all determinative conditions precedent to proper operation of the vehicle are normal. For example, the checking of any power supply output voltage, to be meaningful, must first be preceded by checking battery voltage. Likewise, steering pump motor contactor tips should await the prior measurement of the power steering pump motor supply voltage.

Any subsystem of truck 10 may be diagnostically interrogated in a number of ways. For example, two or more signal lines applied to an activation mechanism of a subsystem may be variously energized and de-energized in various sequences, and the results compared, to determine possible abnormal conditions.

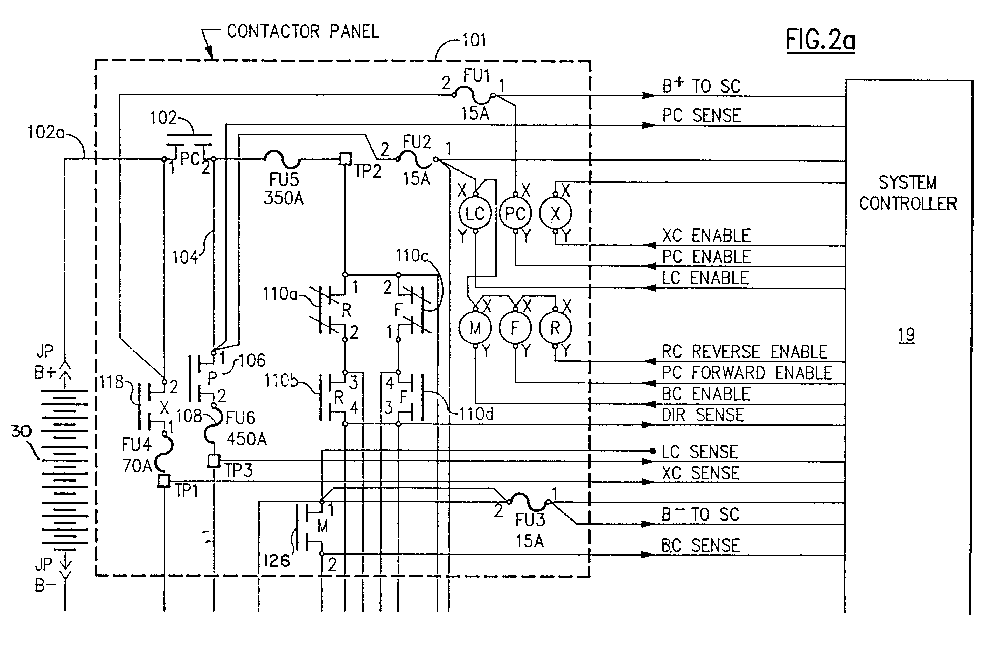

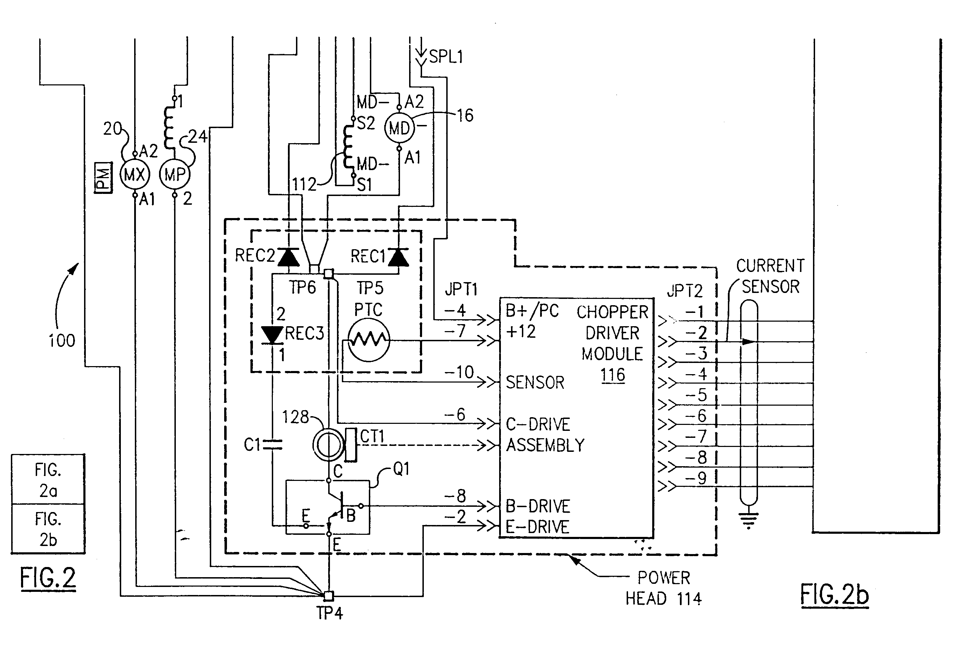

Referring now to FIGURE 2, there is shown an electrical schematic diagram of a set of subsystem components and mechanisms for diagnostically and operatively activating the vehicle. A power electronics panel is shown generally at reference numeral 100. A contactor panel 101 is connected to battery 30 over line 102a. Contactor panel 101 includes six contactors in the preferred embodiment. The main contactor is a power contactor 102. A lift contactor 106 is connected to power contactor 102 by means of line 104. Contactor 106 provides power from power contactor 102 to the lift pump motor 24 (FIGURES 1 and 2). Between lift contactor 106 and motor 24 is disposed a fuse 108.

Also connected to power contactor 102 are two pairs of directional contactors 110a-110d. Directional contactors 110a-110d are connected by means of field winding 112 to traction motor 16. Forward contactor 110c and 110d applies power from the power contactor 102 in the forward direction to motor 16. Likewise, reverse contactor 110a and 110b applies power from power contactor 102 in the reverse direction to drive motor 16.

Connected to traction motor 16 is a power head, shown generally at reference numeral 114. Power head 114 includes a chopper driver module 116 for converting low level signals from system controller 19 (FIGURES 1 and 2) to high current and high voltage power for traction motor 16. Connected to chopper driver module 116 is power transistor Q1, which draws current to the negative side of the armature of motor 16 from the B- terminal of battery 30.

Bypass contactor 126 is provided to shunt current around transistor Q1 so that maximum power is applied to the armature of motor 16. In operation, bypass contactor 126 is used when a vehicle speed is chosen for which no speed control is required. In such a case, the power transistor Q1 need not be energized.

An auxiliary contactor 118 is provided in contactor panel 101 to energize steering pump motor 20. Auxiliary contactor 118 is connected directly to battery 30 so that faults in the traction and/or lift system do not affect steering operations. Therefore, steering motor 20 may be tested without first activating power contactor 102.

Bypass contactor 126 is used to shunt current around drive transistor Q1 to eliminate power usage thereby.

Signals are applied to or detected from vehicle power panel 100 by system controller 19 and are labelled appropriately. The signals are applied and/or detected in accordance with the procedure described hereinbelow. The subsystems are tested by means of detecting voltage at contactor tips. The operation of the power head 114, however, requires current sensing, which is accomplished using a current sensor 128.

In dynamically testing contactors 102, 106, 118, 110a-110d and 126, the contactors are opened and closed. Passive testing occurs for the subsystems associated with these contactors by means of detecting shorted contacts.

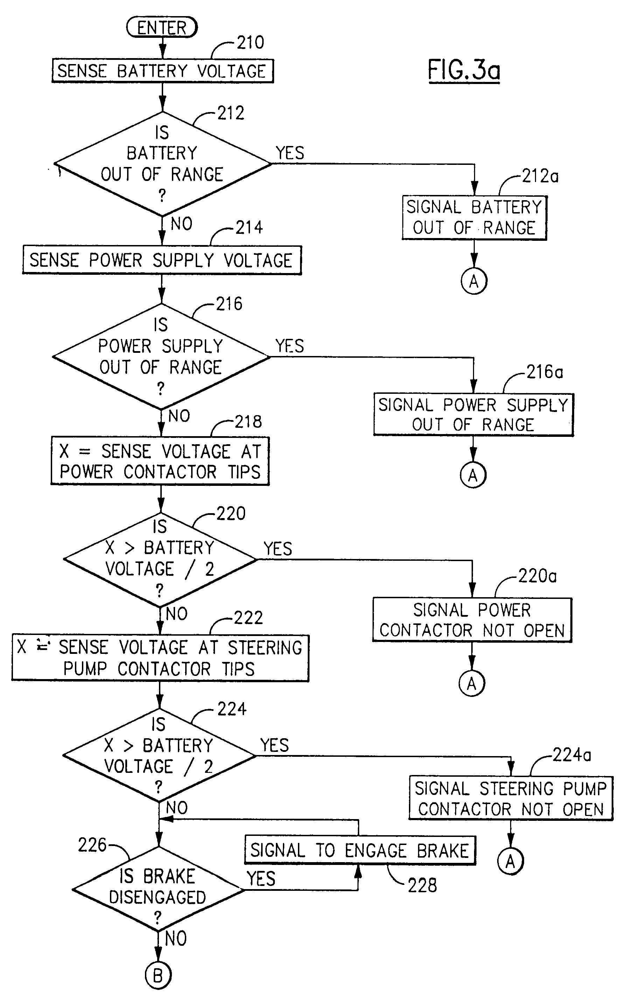

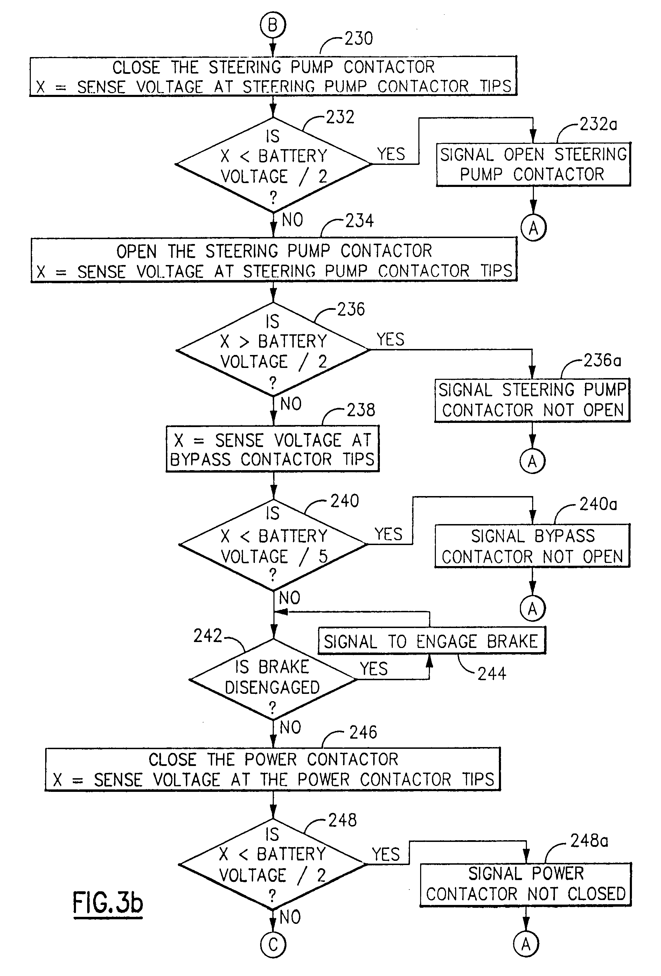

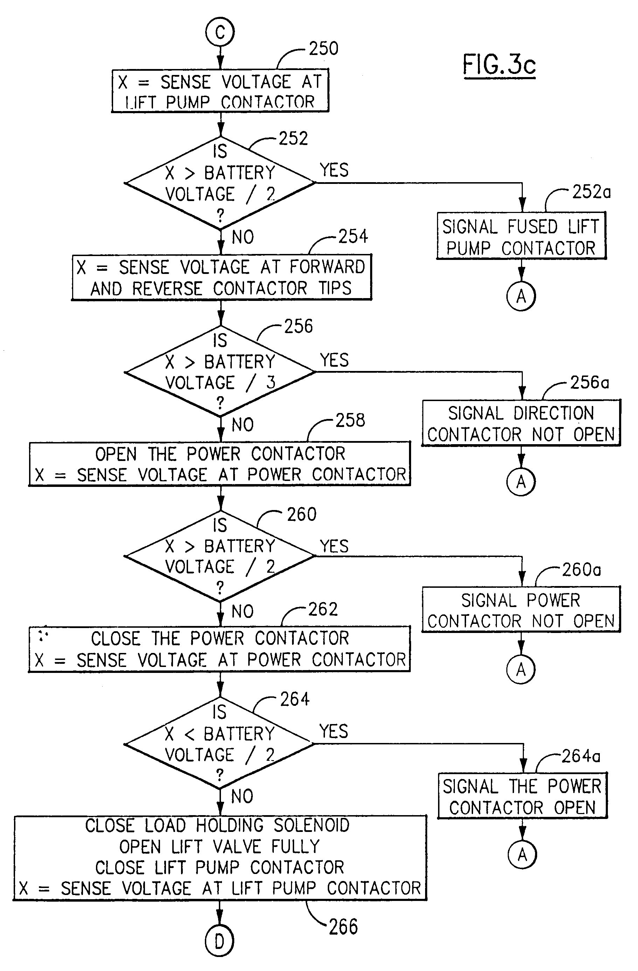

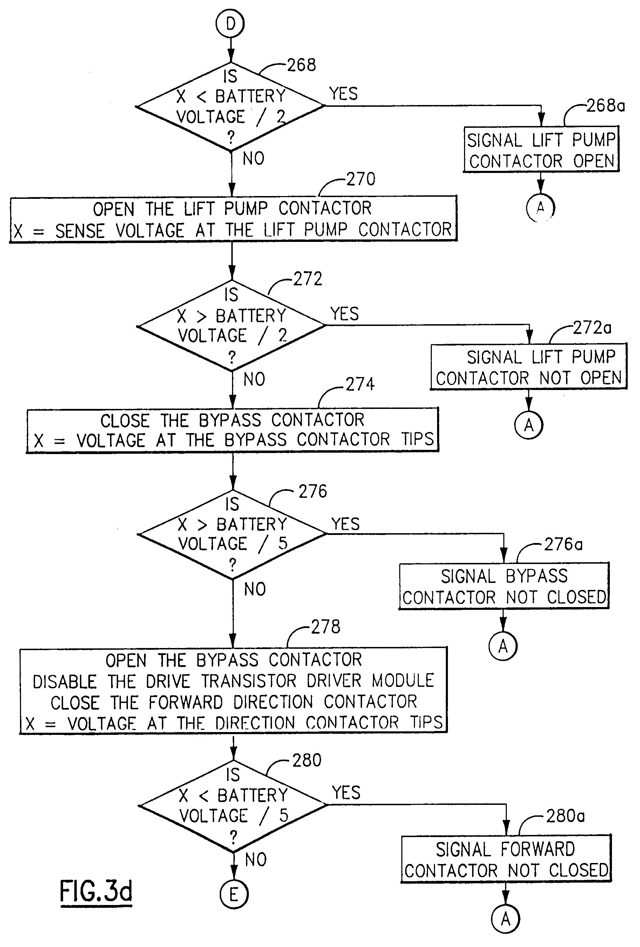

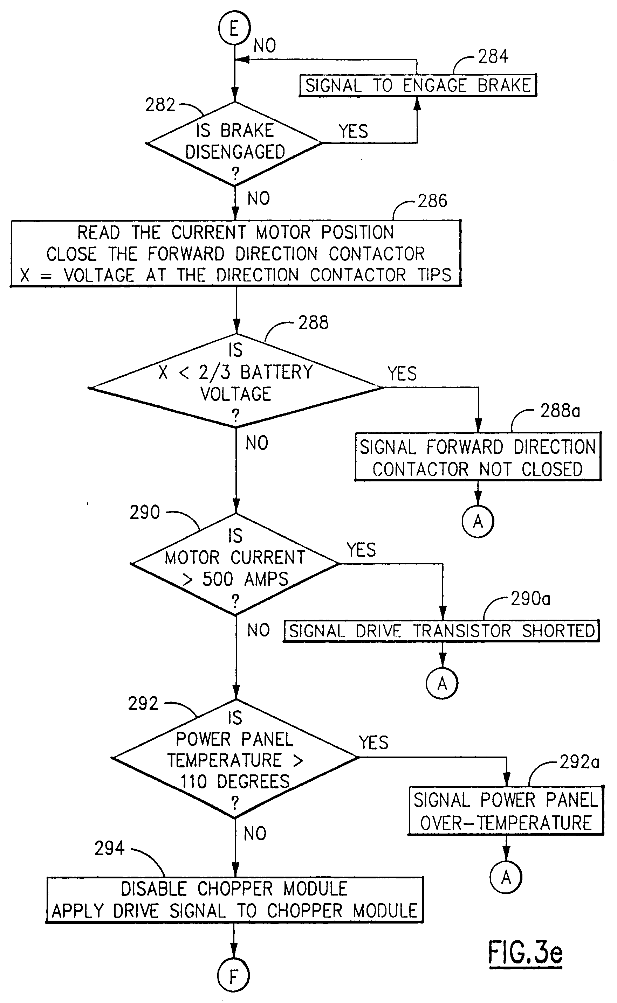

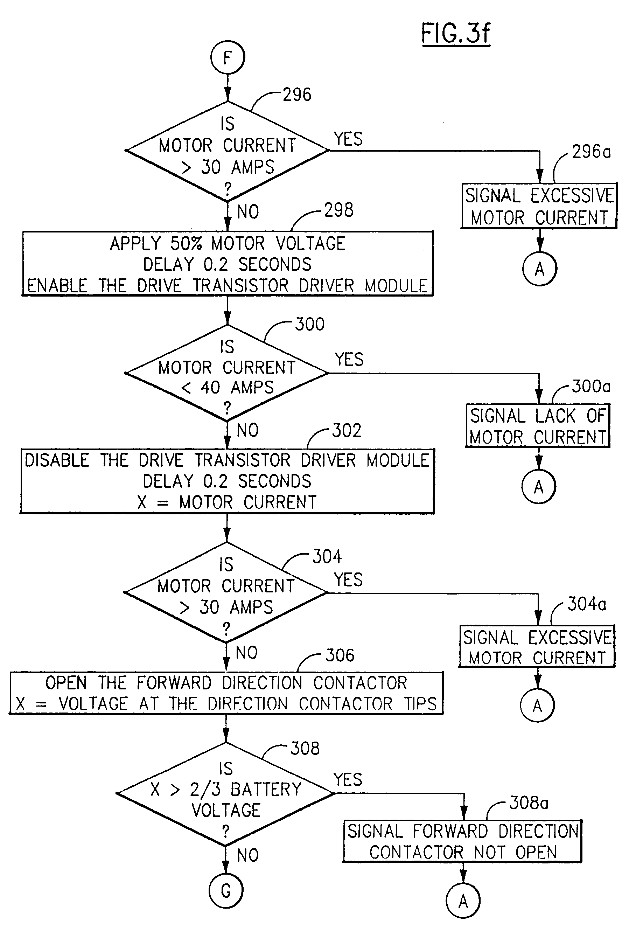

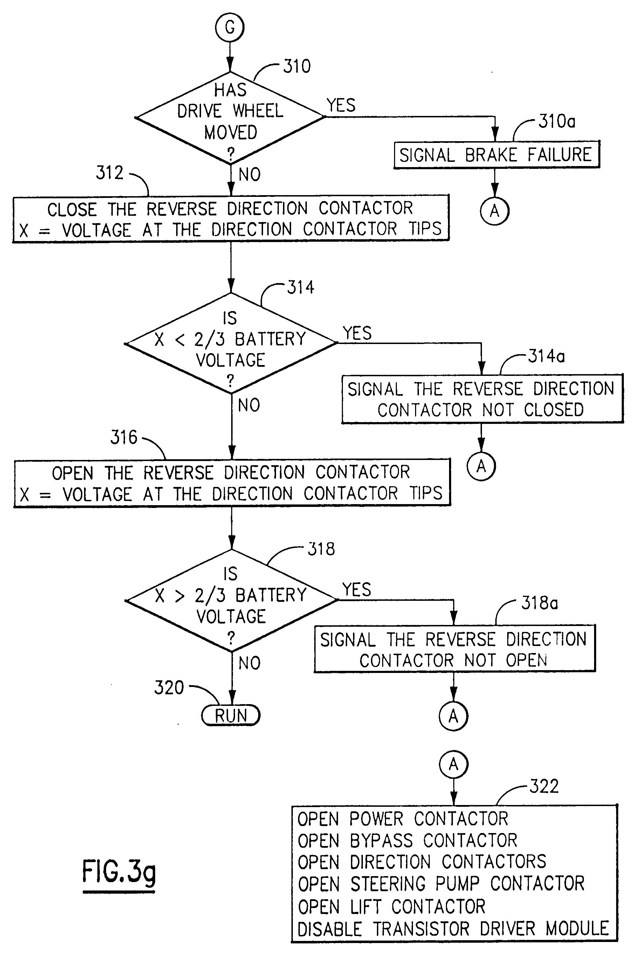

Referring now also to FIGURES 3a-3g, there is shown a flow chart illustrating an exemplary logical sequence of the startup (pre-initializing) diagnostic test for truck 10, according to the present invention. FIGURES 3a-3g show only one preferred logical sequence of diagnostic testing for the truck of FIGURE 1, but it is to be understood that other test sequences are within the scope of the invention as defined in the claims. For purposes of description, it would be helpful to refer to FIGURE 2 for a complete understanding of the diagnostic operations. In the preferred embodiment, the various steps of the test are directed by the controller 19, which may comprise any suitable sequential operation type processor, such as a Model No. 68HCll microcontroller, manufactured by Motorola Co.

As shown in FIGURE 3a, the first component of the vehicle system to be diagnostically interrogated is the output voltage of the battery pack 30, step 210. The system determines whether the battery is outside of its normal voltage range, step 212. If this measured voltage is found to be outside of the normal range, a signal is sent to the operator, indicating that fact, step 212a.

In FIGURES 3a-3g, the vehicle shutdown routine is conveniently denoted by the letter "A", and described in greater detail hereinbelow. After most vehicle subsystems have been shut down, the operator is informed of the diagnostic status. The operator is then given the option of attempting to re-start the vehicle.

If the measured voltage is within the desired normal range, step 212, the system measures the power supply voltage, step 214.

The system then determines whether the power supply voltage is outside of the desired normal range, step 216. If so, the operator is signalled accordingly, step 216a. If, however, the measured power supply is not out of range, step 216, the voltage at the tips of the power contactor 102 is sensed, step 218. If this voltage is greater than 1/2 of the battery voltage, step 220, the operator is signalled that the power contactor is not open. If, however, the measured voltage is not greater than 1/2 of the battery voltage, step 220, the voltage is measured at the steering pump contactor tips, step 222.

The system then determines whether the measured steering pump contactor voltage is greater than 1/2 of the battery voltage, step 224. The system then determines whether the brake is engaged, step 226. If the brake is not engaged, a signal is sent to the operator, informing him or her of that fact, step 228.

The steering pump contactor is then closed, and voltage at the steering pump contactor tips is sensed, step 230. If the voltage at the steering pump contactor tips is greater than 1/2 of the battery voltage, step 232, the system opens the steering pump contactor, step 234, and senses the voltage at the steering pump contactor tips, step 236, determining whether the measured voltage is greater than 1/2 of the battery voltage.

The system senses voltage at the bypass contactor tips, step 238 and determines whether the measured voltage at the bypass contactor tips is less than 1/5 of the battery voltage, step 240.

The system then determines whether the brake is engaged, step 242. If the brake is not engaged, a signal is sent to the operator, informing him or her of that fact, step 244.

Once the brake is engaged, the power contactor may be closed by the system, and voltage at the power contactor tips can be measured, step 246. If the measured voltage at the power contactor tips is less than 1/2 of the battery voltage, step 248, the operator is signalled accordingly, step 248a. If, however, the measured voltage at the power contactor tips is not less than 1/2 of the battery voltage, step 248, then the system senses the voltage at the lift pump contactor, step 250.

The system then determines whether the voltage measured at the lift pump contactor is greater than 1/2 of the battery voltage, step 252. If this is not the case, indicating that the lift pump contactor is not closed, the system then senses the voltage at the forward and reverse contactor tips, step 254. If the measured voltage at the forward and reverse contactor tips is greater than 1/3 of the battery voltage, the operator is signalled that the direction contactor is not open, step 256a. If, however, the measured voltage is not greater than 1/3 of the battery voltage, step 256, then the power contactor is opened and the system senses the voltage at the power contactor, step 258.

The system then determines whether the measured voltage at the power contactor is greater than 1/2 of the battery voltage, step 260. If the measured voltage at the power contactor is less than or equal to 1/2 of the battery voltage, the system then closes the power contactor and once again senses the voltage at the power contactor, step 262.

The system then determined whether the measured voltage at the power contactor is greater than 1/2 of the battery voltage, step 264. If the measured voltage at the power contactor is greater than 1/2 of the battery voltage, the operator is signalled that the power contactor is open, step 264a. If, however, the measured voltage is not less than 1/2 of the battery voltage, step 264, the system closes the load holding solenoid, opens the lift valve, closes the lift pump contactor, and measures the voltage at the lift pump contactor, step 266.

The system then determines whether the measured voltage at the lift pump contactor is less than 1/2 of the battery voltage, step 268. If so, the operator is signalled accordingly, step 268a.

If the voltage at the lift pump contactor is not less than 1/2 of the battery voltage, step 268, the system opens the lift pump contactor, and senses the voltage at the lift pump contactor, step 270. The system then determines whether the voltage at the lift pump contactor is greater than 1/2 of the battery voltage, step 272. If so, the system indicates to the operator that the lift pump contactor is not open, step 272a.

If, however, the measured voltage at the lift pump contactor is not greater than 1/2 of the battery voltage, step 272, the system closes the bypass contactor and senses the voltage at the bypass contactor tips, step 274.

The system then determines whether the measured voltage at the bypass contactor tips is greater than 1/5 of the battery voltage, step 276. If so, the operator is signaled that the bypass contactor is not closed, step 276a. If, however, the measured voltage at the bypass contactor tips is not greater than 1/5 of the battery voltage, step 276, the system opens the bypass contactor, disables the drive transistor driver module, and senses the voltage at the direction contactor tips, step 278.

The system then determines whether the voltage at the direction contactor tips is less than 1/5 of the battery voltage, step 280. If so, the operator is signalled to indicate that the bypass contactor is not open, step 280a.

The system then again determines whether the brake is engaged, step 282. If the brake is not engaged, a signal is sent to the operator, informing him or her of that fact, step 284.

The system then reads the current position of the traction motor, closes the forward direction contactor and senses the voltage at the direction contactor tips, step 286. The system then determines whether the measured voltage at the direction contactor tips is less than 2/3 of the battery voltage, step 288. If so, a signal is sent to the operator indicating that the forward direction contactor is not closed, step 288a. If, however, the measured voltage at the direction contactor tips is not less than 2/3 of the battery voltage, step 288, the system then determines whether the measured motor current is greater than 500 amps, step 290. If so, the operator is signalled to indicate that the drive transistor is shorted, step 290a.

If, however, the motor current is not greater than 500 amps, step 290, the system determines whether the power panel temperature is greater than 110°, step 292. If so, the operator is signalled to indicate that the power panel has exceeded its normal operating temperature, step 292a.

If, however, the power panel temperature is not greater than 110°, step 292, the system disables the chopper module, then applies a drive signal thereto and senses the motor current, step 294.

If the motor current is greater than 30 amps, step 296, the operator is signalled to indicate that the measured motor current is excessive, step 296a. If, however, the measured motor current is not greater than 30 amps, the system applies a 50% drive signal to the motor, enables the drive transistor driver module, and senses the present motor current, step 298. If the motor current is less than 40 amps, step 300, the operator is signalled to indicate that the motor current is insufficient for proper operation, step 300a.

If, however, the motor current is not less than 40 amps, step 300, the system disables the drive transistor driver module and measures the motor current once again, step 302. If the motor current is greater than 30 amps, step 304, the operator is signalled to indicate that the motor current is excessive, step 304a.

If the motor current is not greater than 30 amps, step 304, the forward direction contactor is opened and the voltage at the direction contactor tips is sensed, step 306.

If the measured voltage at the direction contactor tips is greater than 2/3 of the battery voltage, step 308, the operator is signalled to indicate that the forward direction contactor is not open, step 308a.

The system then determines whether the drive wheel has moved, step 310. If so, a signal indicating a weak braking condition is generated and sent to the operator, step 310a.

If the drive wheel has not moved, step 310, the system closes the reverse direction contactor and senses the voltage at the direction contactor tips, step 312. If the measured voltage at the direction contactor tips is less than 2/3 of the battery voltage, step 314, the operator is signalled to indicate that the forward direction contactor is not closed, step 314a. The system then opens the reverse direction contactor and detects the voltage at the direction contactor tips once again, step 316.

The system then determines whether the voltage at the direction contactor tips is greater than 2/3 of the battery voltage, step 318. If so, a signal is sent to the operator to indicate that the reverse direction contactor is not open, step 318a. If the measured voltage at the direction contactor tips is not greater than 2/3 of the battery voltage, step 318, all subsystems of the vehicle have been cleared for operation and the vehicle may begin operating, step 320.

At each of the passive and active test points in the diagnostic sequence described hereinabove, the vehicle operator is given a visual and/or an audible signal when a failure of any one of the subsystems occurs.

Simultaneously and automatically, the vehicle 10 is disabled from traveling and lifting (but not from lowering or steering). Shut down is accomplished in a safe and non-damaging fashion, step 322, as shown by reference letter "A" throughout FIGURES 3a-3g. For example, the various appropriate power switching contactors can be opened for this purpose, as indicated, step 322.

Since other modifications and changes varied to fit particular operating requirements and environments will be apparent to those skilled in the art, the invention is not considered limited to the example chosen for purposes of disclosure, and covers all changes and modifications which do not constitute departures from the scope of the invention as defined in the claims.

## Claims

1. Method for performing sequential diagnostic tests on a plurality of components and subsystems that operate a material handling vehicle, for pre-initializing said material handling vehicle prior to its operation, said method performed by a system and comprising the steps of:
a) the system selects a first one of said plurality of components and subsystems for performing a first diagnostic test thereupon;
b) the system interrogates said selected first one of said plurality of components and subsystems;
said method being further **characterized** by comprising the steps of
c) the system determines whether the selected first one of said plurality of components or subsystems is within a satisfactory operational state;
d) the system selects at least a second component or subsystem of said plurality of components and subsystems that is dependent for its operation upon said first one of said plurality of components and subsystems for performing a second diagnostic test thereupon if said first one of said plurality of components and subsystems is within a normal operating range, and, if not within a normal operating range, prevents initialization of said material handling vehicle prior to its operation;
e) the system interrogates said second component and subsystem of said plurality of components and subsystems;
f) the system determines whether said second component or subsystem of said plurality of components and subsystems is within a satisfactory operational state; and
g) the system initialises said material handling vehicle for movement, if at least said second component or subsystem of said plurality of components and subsystems is within a normal operating range, and, if it is not within said normal operating range, prevents initialization of said material handling vehicle prior to its operation.

2. The method for performing sequential diagnostic tests as claimed in claim 1, wherein the selecting steps (a) and (d) are performed in accordance with a programmable diagnostic sequence.

3. The method for performing sequential diagnostic tests as claimed in claim 2, further comprising the steps of:
h) selecting additional components or subsystems of said plurality of components and subsystems for performing diagnostic tests thereupon in accordance with said programmable diagnostic sequence;
i) interrogating said additional components or subsystems of said plurality of components and subsystems in their proper order according to said programmable diagnostic sequence; and
j) determining whether said additional components or subsystems of said plurality of components and subsystems are within a satisfactory operational state.

4. The method for performing sequential diagnostic tests as claimed in claim 3, further comprising the step of:
k) signalling whether any component or subsystem of said plurality of components and subsystems is not within a satisfactory operational state.

5. The method for performing sequential diagnostic tests as claimed in any preceding claim, further comprising the steps of:
l) determining whether a brake of said material handling vehicle is engaged; and
m) signalling an operator of said material handling vehicle to engage said brake if it is determined that the brake is disengaged.

6. The method for performing sequential diagnostic tests as claimed in any preceding claim, wherein the first one of said plurality of components and subsystems is a drive system.

7. The method for performing diagnostic sequential tests as claimed in claim 6, further comprising the steps of:
applying power to said drive system; and
determining whether a brake of said material handling vehicle is functional.

8. The method for performing diagnostic sequential tests as claimed in any preceding claim, wherein at least one of said determining steps is performed after a predetermined time delay.

9. The method for performing diagnostic sequential tests as claimed in any preceding claim, wherein at least one of said determining steps comprises a dynamic diagnostic test.

10. System for performing sequential diagnostic tests on a plurality of components and subsystems that operate a material handling vehicle, for pre-initializing said material handling vehicle prior to its operation, said system comprising :
a microcontroller operatively connected to a power circuit of a material handling vehicle, and containing a diagnostic programm for sequentially testing components and subsystems of said power circuit in accordance with the following steps :
a) the system selects a first one of said plurality of components and subsystems for performing a first diagnostic test thereupon;
b) the system interrogates said selected first one of said plurality of components and subsystems;
said system being further **characterized** by comprising the steps of
c) the system determines whether the selected first one of said plurality of components or subsystems is within a satisfactory operational state and if satisfactory, proceeds with pre-initializing said material handling vehicle at step d), and if not, then prevents the initializing of said material handling vehicle;
d) the system selects at least a second component or subsystem of said plurality of components and subsystems that is dependent for its operation upon said first one of said plurality of components and subsystems for performing a second diagnostic test thereupon, if said first one of said plurality of components and subsystems is within a normal operating range;
e) the system interrogates said second component or subsystem of said plurality of components and subsystems;
f) the system determines whether said second component or subsystem of said plurality of components and subsystems is within a satisfactory operational state; and
g) the system initialises said material handling vehicle for movement, if at least said second component or subsystem of said plurality of components and subsystems is within a normal operating range, and, if it is not within said normal operating range, prevents initialization of said material handling vehicle prior to its operation.

11. The system for performing sequential diagnostic tests as claimed in claim 10, comprising signalling means operatively connected to said microcontroller for signalling whether a component or subsystem is malfunctioning.

12. The system for performing sequential diagnostic tests as claimed in claim 10 or 11, comprising signalling means operatively connected to said microcontroller for signalling an operator of said vehicle to engage a brake of said material handling vehicle.

13. The system for performing sequential diagnostic tests as claimed in claim 11 or 12, wherein said signalling means includes a visual signalling device.

14. The system for performing sequential diagnostic tests as claimed in claim 11 or 12, wherein said signalling means includes an audible signalling device.

15. Method for performing sequential diagnostic tests on a plurality of components and subsystems that operate a material handling vehicle, for pre-initializing said material handling vehicle prior to its operation, said method being performed by a system and **characterized** by the steps of :
a) the system selects at least one component or subsystem of said plurality of components and subsystems that is dependent for its operation upon another one of said plurality of components and subsystems for performing a diagnostic test thereupon if said another one of said plurality of components and subsystems is found to be within a normal operating range, and, if not within a normal range, preventing initialization of said material handling vehicle;
b) the system interrogates said selected component or subsystem of said plurality of components and subsystems;
c) the system determines whether the selected component or subsystem of said plurality of components and subsystems is within a satisfactory operational state; and
d) the system initialises said material handling vehicle for movement if at least said selected component or subsystem of said plurality of components and subsystems is within a normal operating range, and, if it is not within said normal operating range, prevents initialization of said material handling vehicle prior to its operation.

## Patentansprüche

1. Verfahren zur Ausführung einer Folge von Diagnoseprüfungen einer Vielzahl von Komponenten und Untersystemen, die ein Materialhandhabungsfahrzeug betreiben, für eine Vorinitialisierung des Materialhandhabungsfahrzeugs vor seiner Inbetriebnahme, wobei das Verfahren durch ein System ausgeführt wird und folgende Schritte aufweist:
a) das System wählt eine erste Komponente bzw. ein erstes Untersystem aus der Vielzahl der Komponenten und Untersysteme, um dieses einer ersten Diagnoseprüfung zu unterwerfen;
b) das System frägt die gewählte Komponente bzw. das gewählte Untersystem ab;
wobei das Verfahren weiterhin dadurch gekennzeichnet ist, daß es folgende Schritte aufweist:
c) das System ermittelt, ob die gewählte Komponente oder das Untersystem in einem zufriedenstellenden Betriebszustand ist;
d) das System wählt wenigstens eine zweite Komponente oder ein zweites Untersystem aus der Vielzahl der Komponenten und Untersysteme aus, welche bzw. welches in ihrem bzw. seinem Betrieb von der ersten Komponente oder dem ersten Untersystem abhängt, um die zweite Komponente bzw. dieses zweite Untersystem einer zweiten Diagnoseprüfung zu unterwerfen, falls die erste Komponente bzw. das erste Untersystem in einem normalen Betriebsbereich ist, und, falls sie oder es nicht in einem normalen Betriebsbereich ist, verhindert das System die Initialisierung des Materialhandhabungsfahrzeugs vor dessen Betrieb;
e) das System frägt die zweite Komponente bzw. das zweite Untersystem aus der Vielzahl der Komponenten und Untersysteme ab;
f) das System ermittelt, ob die zweite Komponente oder das zweite Untersystem aus der Vielzahl der Komponenten und Untersysteme in einem zufriedenstellenden Betriebszustand ist; und
g) das System initialisiert das Materialhandhabungsfahrzeug für seine Bewegung, wenn wenigstens die zweite Komponente oder das zweite Untersystem aus der Vielzahl der Komponenten und Untersysteme in einem normalen Betriebsbereich ist, und verhindert die Initialisierung des Materialhandhabungsfahrzeugs vor seiner Inbetriebnahme, wenn diese zweite Komponente oder dieses Untersystem nicht im normalen Betriebsbereich liegt.

2. Verfahren zur Ausführung einer Folge von Diagnoseprüfungen nach Anspruch 1, bei dem die Auswahlschritte (a) und (d) in Übereinstimmung mit einer programmierbaren Diagnosefolge ausgeführt werden.

3. Verfahren zur Ausführung einer Folge von Diagnoseprüfungen nach Anspruch 2, das weiterhin die Schritte aufweist:
h) Auswahl zusätzlicher Komponenten oder Untersysteme aus der Vielzahl der Komponenten und Untersysteme, um diese einer Diagnoseprüfung in Übereinstimmung mit der programmierbaren Diagnosefolge zu unterwerfen;
i) Abfragen der zusätzlichen Komponenten oder Untersysteme aus der Vielzahl der Komponenten und Untersysteme in ihrer mit der programmierbaren Diagnosefolge übereinstimmenden geeigneten Folge; und
j) Ermitteln, ob die zusätzlichen Komponenten oder Untersysteme aus der Vielzahl der Komponenten und Untersysteme in einem zufriedenstellenden Betriebszustand sind.

4. Verfahren zur Ausführung einer Folge von Diagnoseprüfungen nach Anspruch 3, das weiterhin den Schritt aufweist:
k) Signalgabe, ob irgendeine Komponente oder irgendein Untersystem aus der Vielzahl der Untersysteme und Komponenten nicht in einem zufriedenstellenden Betriebsbereich ist.

5. Verfahren zur Ausführung einer Folge von Diagnoseprüfungen nach einem der vorangehenden Ansprüche, das weiterhin die Schritte aufweist:
l) Ermitteln, ob eine Bremse des Materialhandhabungsfahrzeugs eingreift; und
m) Signalgabe an einen Betreiber des Materialhandhabungsfahrzeugs, um die Bremse einzurücken, falls ermittelt wurde, daß die Bremse ausgerückt ist.

6. Verfahren zur Ausführung einer Folge von Diagnoseprüfungen nach einem der vorangehenden Ansprüche, bei dem die erste bzw. das erste aus der Vielzahl der Komponenten und Untersysteme ein Antriebsystem ist.

7. Verfahren zur Ausführung einer Folge von Diagnoseprüfungen nach Anspruch 6, das weiterhin den Schritt aufweist:
Zufuhr von Leistung zum Antriebsystem; und
Ermittlung, ob eine Bremse des Materialhandhabungsfahrzeugs funktioniert.

8. Verfahren zur Ausführung einer Folge von Diagnoseprüfungen nach einem der vorangehenden Ansprüche, bei dem wenigstens einer der Ermittlungsschritte nach einer vorgegebenen Verzögerungszeit ausgeführt wird.

9. Verfahren zur Ausführung einer Folge von Diagnoseprüfungen nach einem der vorangehenden Ansprüche, bei dem wenigstens einer der Ermittlungsschritte eine dynamische Diagnoseprüfung aufweist.

10. System zur Ausführung einer Folge von Diagnoseprüfungen einer Vielzahl von Komponenten und Untersystemen, die ein Materialhandhabungsfahrzeug betreiben, für eine Vorinitialisierung des Materialhandhabungsfahrzeugs vor seiner Inbetriebnahme, wobei das System aufweist: einen Mikroprozessor, der operativ mit einer Leistungsschaltung des Materialhandhabungsfahrzeugs verbunden ist und ein Diagnoseprogramm zur sequentiellen Prüfung von Komponenten und Untersystemen der Leistungsschaltung in Übereinstimmung mit folgenden Schritten enthält:
a) das System wählt eine erste bzw. ein erstes aus der Vielzahl von Komponenten und Untersystemen aus, um dieses einer ersten Diagnoseprüfung zu unterwerfen;
b) das System frägt die gewählte Komponente bzw. das gewählte Untersystem aus der Vielzahl von Komponenten und Untersystemen ab;
wobei das System weiterhin dadurch gekennzeichnet ist, daß es folgende Schritte aufweist:
c) das System ermittelt, ob die ausgewählte Komponente oder das ausgewählte Untersystem aus der Vielzahl der Komponenten oder Untersystemen in einem zufriedenstellenden Betriebszustand ist, und fährt, falls dies so ist, mit der Initialisierung des Materialhandhabungsfahrzeugs mit Schritt d)fort, und verhindert, falls dies nicht so ist, die Initialisierung des Materialhandhabungsfahrzeugs;
d) das System wählt wenigstens eine zweite Komponenten oder ein zweites Untersystem aus der Vielzahl von Komponenten und Untersystemen aus, welche bzw. welches in seinem Betrieb von der ersten Komponente bzw. dem ersten Untersystem aus der Vielzahl der Komponenten und Untersystemen abhängt, um diese zweite Komponente bzw. das zweite Untersystem einer zweiten Diagnoseprüfung zu unterwerfen, falls die erste Komponente bzw. das erste Untersystem aus der Vielzahl der Komponenten und Untersystemen in einem normalen Betriebsbereich ist;
e) das System frägt die zweite Komponente oder das Untersystem aus der Vielzahl von Komponenten und Untersysteme ab;
f) das System ermittelt, ob diese zweite Komponente oder das zweite Untersystem aus der Vielzahl der Komponenten und Untersysteme in einem zufriedenstellenden Betriebszustand ist; und
g) das System initialisiert das Materialhandhabungsfahrzeugs für seine Bewegung, wenn wenigstens die zweite Komponente oder das zweite Untersystem aus der Vielzahl von Komponenten und Untersystemen in einem normalen Betriebsbereich liegt, und verhindert die Initialisierung des Materialhandhabungsfahrzeugs vor seiner Inbetriebnahme, falls die zweite Komponente oder das zweite Untersystem nicht im normalen Betriebsbereich liegt.

11. System zur Ausführung einer Folge von Diagnoseprüfungen nach Anspruch 10, welches Signalgäbemittel aufweist, die operativ mit dem Mikroprozessor verbunden sind, um zu signalisieren, ob eine Komponente oder ein Untersystem Fehlfunktionen hat.

12. System zur Ausführung einer Folge von Diagnoseprüfungen nach Anspruch 10 oder 11, welches Signalgabemittel aufweist, die operativ mit dem Mikroprozessor verbunden sind, um einem Betreiber des Fahrzeugs zu signalisieren, eine Bremse des Materialhandhabungsfahrzeugs einzu-rücken.

13. System zur Ausführung einer Folge von Diagnoseprüfungen nach Anspruch 11 oder 12, bei dem die Signalgabemittel eine Sichtsignalgabevorrichtung enthalten.

14. System zur Ausführung einer Folge von Diagnoseprüfungen nach Anspruch 11 oder 12, bei dem die Signalgabemittel eine Hörsignalgabevorrichtung enthalten.

15. Verfahren zur Ausführung einer Folge von Diagnoseprüfungen einer Vielzahl von Komponenten und Untersystemen, die ein Materialhandhabungsfahrzeug betreiben, um dieses einer Vorinitialisierung vor seiner Inbetriebsetzung zu unterwerfen, wobei das Verfahren durch ein System ausgeführt wird und gekennzeichnet ist durch folgende Schritte:
a) das System wählt zur Ausführung einer Diagnoseprüfung wenigstens eine Komponente oder ein Untersystem aus der Vielzahl von Komponenten und Untersystemen aus, welche in ihrem Betrieb von einer anderen Komponente oder einem anderen Untersystem abhängen, falls sich ergibt, daß die andere Komponente oder das andere Untersystem aus der Vielzahl von Komponenten und Untersystemen in einem normalen Betriebsbereich liegt, und verhindert, falls dies nicht der Fall ist, die Initialisierung des Materialhandhabungsfahrzeugs;
b) das System frägt die gewählte Komponente oder das Untersystem aus der Vielzahl von Komponenten und Untersysteme ab;
c) das System ermittelt, ob die ausgewählte Komponente bzw. das ausgewählte Untersystem aus der Vielzahl von Komponenten oder Untersystemen in einem zufriedenstellenden Betriebszustand ist; und
d) das System initialisiert das Materialhandhabungsfahrzeug für seine Bewegung, wenn wenigstens die ausgewählte Komponente oder das ausgewählte Untersystem aus der Vielzahl von Komponenten oder Untersystemen in einem normalen Betriebsbereich ist, und verhindert die Initialisierung des Materialhandhabungsfahrzeugs vor seiner Inbetriebsetzung, falls die ausgewählte Komponente bzw. das ausgewählte Untersystem nicht in ihrem normalen Betriebsbereich liegt.

## Revendications

1. Procédé pour effectuer des tests de diagnostic séquentiels sur une pluralité de composants et de sous-systèmes servant à faire fonctionner un véhicule de manutention de matériaux, afin de préinitialiser ce véhicule préalablement à son fonctionnement, ce procédé étant mis en oeuvre par un système et comprenant les étapes consistant en ce que:
a) le système sélectionne un premier de ladite pluralité de composants et de sous-systèmes pour effectuer un premier test de diagnostic sur lui; et
b) le système interroge ce premier composant ou sous-système sélectionné;
caractérisé en ce qu'il comprend en outre les étapes suivantes:
c) le système détermine si le premier composant ou sous-système sélectionné de ladite pluralité de composants et de sous-systèmes est dans un état de fonctionnement satisfaisant;
d) le système sélectionne au moins un deuxième composant ou sous-système de ladite pluralité de composants et de sous-systèmes dont le fonctionnement dépend du premier composant ou sous-système sélectionné pour effectuer un deuxième test de diagnostic sur lui si le premier composant ou sous-système sélectionné est dans une plage normale de fonctionnement et, si tel n'est pas le cas, empêche l'initialisation du véhicule de manutention de matériaux préalablement à son fonctionnement;
e) le système interroge le deuxième composant ou sous-système sélectionné;
f) le système détermine si le deuxième composant ou système sélectionné est dans un état de fonctionnement satisfaisant; et
g) le système initialise le véhicule de manutention de matériaux, afin qu'il puisse effectuer des mouvements, si au moins le deuxième composant ou sous-système sélectionné est dans une plage normale de fonctionnement et, si tel n'est pas le cas, empêche l'initialisation du véhicule de manutention de matériaux préalablement à son fonctionnement.

2. Procédé pour effectuer des tests de diagnostic séquentiels selon la revendication 1, dans lequel les étapes de sélection (a) et (d) sont effectuées d'après une séquence de diagnostic programmable.

3. Procédé pour effectuer des tests de diagnostic séquentiels selon la revendication 2, comprenant en outre les étapes consistant à:
h) sélectionner des composants ou sous-systèmes additionnels de ladite pluralité de composants et de sous-systèmes pour effectuer des tests de diagnostic sur eux d'après la séquence de diagnostic programmable;
i) interroger les composants ou sous-systèmes sélectionnés, l'interrogation s'effectuant dans l'ordre convenable de ces composants ou sous-systèmes et en conformité avec la séquence de diagnostic programmable; et
j) déterminer si lesdits composants ou sous-systèmes additionnels sont dans un état de fonctionnement satisfaisant.

4. Procédé pour effectuer des tests de diagnostic séquentiels selon la revendication 3, comprenant en outre l'étape consistant à:
k) signaler si un quelconque composant ou sous-système de ladite pluralité de composants et de sous-systèmes n'est pas dans un état de fonctionnement satisfaisant.

5. Procédé pour effectuer des tests de diagnostic séquentiels selon l'une quelconque des revendications précédentes, caractérisé en outre en ce qu'il comprend les étapes consistant à:
l) déterminer si un frein du véhicule de manutention de matériaux est serré; et
m) signaler à un opérateur de ce véhicule qu'il doit serrer ce frein s'il est déterminé que le frein n'est pas serré.

6. Procédé pour effectuer des tests de diagnostic séquentiels selon l'une quelconque des revendications précédentes, dans lequel le premier composant ou sous-système sélectionné de ladite pluralité de composants et de sous-systèmes est un système de commande.

7. Procédé pour effectuer des tests de diagnostic séquentiels selon la revendication 6, comprenant en outre les étapes consistant à:
fournir l'énergie à ce système de commande; et déterminer si un frein du véhicule de manutention de matériaux est fonctionnel.

8. Procédé pour effectuer des tests de diagnostic séquentiels selon l'une quelconque des revendications précédentes, dans lequel au moins l'une desdites étapes de détermination est effectuée après un temps de retard prédéterminé.

9. Procédé pour effectuer des tests de diagnostic séquentiels selon l'une quelconque des revendications précédentes, dans lequel au moins l'une des étapes de détermination comprend un test de diagnostic dynamique.

10. Système pour effectuer des tests de diagnostic séquentiels sur une pluralité de composants et de sous-systèmes servant à faire fonctionner un véhicule de manutention de matériaux, afin de préinitialiser ce véhicule préalablement à son fonctionnement, ce système comprenant:
un microcontrôleur connecté fonctionnellement à un circuit de puissance du véhicule de manutention de matériaux et contenant un programme de diagnostic pour tester séquentiellement des composants et des sous-systèmes de ce circuit de puissance selon les étapes suivantes:
a) le système sélectionne un premier de ladite pluralité de composants et de sous-systèmes pour effectuer un premier test de diagnostic sur lui; et
b) le système interroge ce premier composant ou sous-système sélectionné de ladite pluralité de composants et de sous-systèmes;
caractérisé en outre par les étapes suivantes:
c) le système détermine si le premier composant ou sous-système sélectionné de ladite pluralité de composants et de sous-systèmes est dans un état de fonctionnement satisfaisant et, si tel est le cas, procède à la préinitialisation du véhicule de manutention de matériaux à l'étape (d), tandis que, si tel n'est pas le cas, empêche l'initilisation de ce véhicule;
d) le système sélectionne au moins un deuxième composant ou sous-système de ladite pluralité de composants et de sous-systèmes dont le fonctionnement dépend du premier composant ou sous-système sélectionné pour effectuer un deuxième test de diagnostic sur lui si le premier composant ou sous-système sélectionné est dans une plage normale de fonctionnement;
e) le système interroge le deuxième composant ou sous-système sélectionné de ladite pluralité de composants et de sous-systèmes;
f) le système détermine si le deuxième composant ou sous-système sélectionné est dans un état de fonctionnement satisfaisant; et
g) le système initialise le véhicule de manutention de matériaux, de manière qu'il puisse effectuer des mouvements, si au moins le deuxième composant ou sous-système sélectionné de ladite pluralité de composants et de sous-systèmes est dans une plage normale de fonctionnement, tandis que, si tel n'est pas le cas, empêche l'initilisation de ce véhicule préalablement à son fonctionnement.

11. Système pour effectuer des tests de diagnostic séquentiels selon la revendication 10, comprenant un moyen de signalisation connecté fonctionnellement au microcontrôleur et destiné à fournir un signal si un composant ou un sous-système fonctionne mal.

12. Système pour effectuer des tests de diagnostic séquentiels selon la revendication 10 ou 11, comprenant un moyen de signalisation connecté fonctionnellement au microcontrôleur et servant à signaler à un opérateur du véhicule qu'il doit serrer un frein de ce véhicule.

13. Système pour effectuer des tests de diagnostic séquentiels selon la revendication 11 ou 12, dans lequel le moyen de signalisation comporte un dispositif de signalisation visuelle.

14. Système pour effectuer des tests de diagnostic séquentiels selon la revendication 11 ou 12, dans lequel le moyen de signalisation comporte un dispositif de signalisation sonore.

15. Procédé pour effectuer des tests de diagnostic séquentiels sur une pluralité de composants et de sous-systèmes servant à faire fonctionner un véhicule de manutention de matériaux, afin de préinitialiser ce véhicule préalablement à son fonctionnement, le procédé étant mis en oeuvre par un système et caractérisé par les étapes consistant en ce que:
a) le système sélectionne au moins un composant ou sous-système de -ladite pluralité de composants et de sous-systèmes dont le fonctionnement dépend d'un autre composant ou sous-système de ladite pluralité pour effectuer sur lui un test de diagnostic s'il est constate que cet autre composant ou sous-système est dans une plage normale de fonctionnement et, si tel n'est pas le cas, pour empêcher l'initialisation du véhicule de manutention de matériaux;
b) le système interroge le composant ou le sous-système sélectionné de ladite pluralité de composants et de sous-systèmes;
c) le système détermine si le composant ou le sous-système sélectionné de ladite pluralité de composants et de sous-systèmes est dans un état de fonctionnement satisfaisant; et
d) le système initialise le véhicule de manutention de matériaux, afin qu'il puissse effectuer des mouvements, si au moins le composant ou le sous-système sélectionné de ladite pluralité de composants et de sous-systèmes est dans une plage normale de fonctionnement, tandis que, si tel n'est pas le cas, pour empêcher l'initialisation du véhicule de manutention de matériaux préalablement à son fonctionnement.
